# EUROPEAN PATENT SPECIFICATION

(11) **EP 0 419 087 B1**
(45) Date of publication and mention of the grant of the patent: **16.03.1994**
(21) Application number: 90309666.7
(22) Date of filing: 04.09.1990
(51) Int. Cl.: C23C 16/26, C23C 16/56

(54) **A process for the production of abrasives**
Verfahren zur Herstellung von Schleifmitteln
Méthode de production d'abrasifs

(30) Priority: 06.09.1989 JP 229314/89
(43) Date of publication of application: 27.03.1991
(73) Proprietor: SUMITOMO ELECTRIC INDUSTRIES, LTD., Osaka-shi, Osaka 541 (JP)
(72) Inventor: Yashiki, Tetsuo, c/o Itami Works of Sumitomo, Itami-shi, Hyogo-ken (JP); Fujimori, Naoji, c/o Itami Works of Sumitomo, Itami-shi, Hyogo-ken (JP)
(74) Representative: Allard, Susan Joyce

(56) References cited:
- EXTENDED ABSTRACTS, SPRING MEETING, Los Angeles, CA, 7th - 12th May 1989, 1989, 89/1, page 153, Princeton, NJ, US; L.S. PLANO et al.: "Oxidation of CVD diamond films"
- PATENT ABSTRACTS OF JAPAN, vol. 12, no. 11 (C-468)[2858], 13th January 1988; & JP-A-62 167 883
- JAPANESE JOURNAL OF APPLIED PHYSICS, vol. 28, no. 6, June 1989, part 2, pages 1058-1060, Tokyo, JP; T. CHONAN et al.: "The preparation and characterization of diamond powder by DC arc plasma"
- APPLIED PHYSICS LETTERS, vol. 54, no. 26, 26th June 1989, page 2728, New York, US; S. ALBIN et al.: "Diamond films for laser hardening"

## Description

This invention relates to a process for the production of abrasives of single crystal or polycrystalline diamond.

Diamond abrasive grits have been used as abrasives of abrasive wheels for cutting and grinding and classified into the grades of SD (saw blade), MD (metal bond), RD (resin bond) and micron powder. As the diamond for such abrasives, grits or powders of natural diamond or synthetic diamond are generally used. The synthetic diamond grits or powders can generally be synthesized by a static high pressure method and a part of which can be synthesized by a shock wave method.

The static high pressure method comprises mixing graphite with Group VIII metals (Fe, Co, Ni, etc.) of the Periodic Table, which act as a fusing agent for carbon, and maintaining this mixture at a high temperature and high pressure, for example, 1300°C and 5 GPa or more for a constant period of time, thus depositing diamond.

The shock wave method comprises enclosing graphite in a target, bringing a shock plate at a high speed into collision with the target and generating a strong shock wave in the target, or applying a shock wave by explosion onto the target, thereby converting the graphite directly into diamond.

In a process for the production of abrasives from an artificial synthetic diamond prepared by the above described static high pressure method or shock wave method, however, a complicated step is required to remove the synthesized diamond in any case. When pulverizing is carried out therefor, an apparatus for generating a large impulsive force is thus required and the pulverized diamond has such a large grain size distribution that a step for classifying the grain size is required. Furthermore, the diamond grains obtained by the pulverization generally have a non-isotropic shape with sharp edges, which should be avoided in an appliance needing a particularly precise finished surface, for example, in a process for the production of a semiconductor.

We have now developed a process for the production of abrasives each consisting of single crystal diamond or polycrystalline diamond and a process for producing diamond abrasives with a uniform grain size and an isotroptic shape in simple manner, whereby the above described problems of the prior art can be overcome.

Accordingly, the present invention provides a process for the production of abrasives of single crystal or polycrystalline diamond, which comprises synthesizing a diamond film by a gaseous phase synthesis method, subjecting the resulting diamond film to an etching treatment in an atmosphere containing oxygen and pulverizing the diamond film.

The accompanying drawings are to illustrate in detail the principle and merits of the present invention.

Figure 1 is a schematic view, in cross section, of a diamond film formed by gaseous phase synthesis.

Figure 2 is a schematic view, in cross section, of the diamond film of Figure 1, after etching by a heat treatment in an oxygen-containing atmosphere.

Figure 3 to Figure 5 are graphs each showing grain size distributions, Figure 3 being that of a product obtained in Example 1, Figure 4 being that of a product obtained in Comparative Example 1 and Figure 5 being that of a product obtained in Example 2.

In order to obtain diamond abrasives with a uniform size distribution without complicated steps we have found that a diamond film formed by a CVD method may be subjected to an etching treatment in an oxygen-containing atmosphere and the diamond film then pulverized.

The above described etching treatment is preferably carried out by a heat treatment in an atmosphere containing oxygen at normal or reduced pressure, a plasma treatment in an atmosphere containing oxygen, an ion beam treatment in an atmosphere containing oxygen or a laser etching treatment in an atmosphere containing oxygen.

In the present invention, a film-shaped diamond formed by a gaseous phase synthesis method is treated in an oxygen-containing atmosphere to promote etching along the grain boundary and then pulverized to obtain diamond grains.

In the present invention, synthesis of the film-shaped diamond can be carried out by any of known techniques commonly used in this field, for example, hot filament CVD methods, laser CVD methods, microwave CVD methods, combustion methods, plasma jet methods, ion beam methods and the like.

The film thickness is generally in the range of several µm to 2 mm, depending on the film-forming methods, for example, several µm to several ten µm in the case of the laser CVD methods or ion beam methods, several µm to several hundreds µm in the case of the microwave plasma CVD methods or hot filament CVD methods, and several hundreds µm to 2 mm in the case of the plasma jet methods or combustion methods.

Since many of the diamond films synthesized by these methods are polycrystalline and the crystal grain diameter can be changed by changing the parameter in each of the methods, the diamond grain diameters can be extended to a range of 0.5 to several hundreds µm.

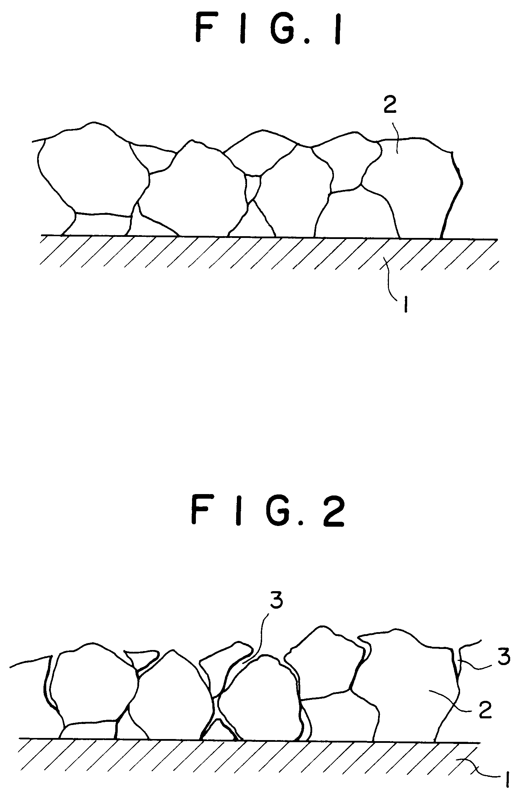

Generally, such a diamond film contains a very small quantity of amorphous carbon or graphite along the grain boundary. A schematic view, in cross section, of a diamond-film obtained by a gaseous phase synthesis method is shown in Fig. 1, in which 1 designates a substrate and 2 designates diamond crystal grains. In the present invention, as the substrate, there can be used, any of materials capable of resisting the diamond synthesis temperature (800 to 1100 °C) and being removed after the coating the diamond film by any treatment such as dissolving and removing, or stripping the film, for example, polycrystalline silicon, single crystal silicon, molybdenum, tungsten, niobium, quarts, etc. Particularly, it is preferable to use single crystal silicon from the stand-point of the ease of dissolving and removing, and the price thereof.

When the thus obtained diamond film was treated in an oxygen-containing atmosphere, the grain boundary and amorphous carbon or graphite present in the grain boundary are preferentially etched and the cross-sectional structure of the diamond film becomes a structure having a groove 3 formed along the grain boundary. This is due to that the reactivity with oxygen is largely different between diamonds and graphite or amorphous carbon, for example, amorphous carbon or graphite is oxidized in the air at a temperature of about 500 °C or higher, while diamond is not oxidized and is stable up to about 800 °C.

The treatment in an atmosphere, carried out in the present invention, includes a heat treatment in an ordinary atmosphere, a heat treatment in an atmosphere under reduced pressure, plasma treatments utilizing various discharges, an ion beam treatment, a laser etching treatment and the like.

The heat treatment in an ordinary atmosphere is carried out by heating a diamond film to be treated at 400 to 600 °C in a vessel filled with an atmosphere comprising 10 to 100 vol % of oxygen and the balance of an inert gas such as argon or nitrogen under the atmospheric pressure. The heat treatment in an atmosphere under reduced pressure is carried out by reducing the pressure of the atmosphere having the above described composition to 66,66 hPa - 101,325 kPa (50 to 760 Torr) in a vacuum tank. In this case, it is preferable to raise the treatment temperature to 500 to 700 °C from the standpoint of the treatment speed.

The plasma treatment is generally carried out by reducing the pressure of an argon atmosphere containing 2 to 40 vol % of oxygen to 1,33 hPa - 133,3 hPa (1 to 100 Torr), generating glow discharge in this atmosphere by the use of DC (500 V to 3 kV, 10 to 500 mA), RF (13.56 MHz, 100 W to 1 kW) or microwave (2.45 GHz, 100 W to 1 kW) and placing a diamond film to be treated in the thus generated plasma.

In the step of pulverization after removing the substrate, such a diamond film that the grain boundary and impurities existing in the grain boundary are etched is readily pulverized along the groove 3 formed by the etching to yield diamond grits. The pulverization is preferably carried out by ball milling.

The abrasives obtained by the process of the present invention have a grain diameter corresponding to that of the crystal when the diamond film is formed, i.e. in the range of 0.5 to several hundreds µm.

The diamond abrasives produced by the process of the present invention each have a size of crystal grains formed during synthesis of the diamond film and accordingly, the grain size is uniform. Therefore, the step of sieving or sorting the grain size, after the step of pulverizing, can largely be simplified.

Furthermore, the diamond abrasives of the present invention have an isotropic shape corresponding to diamond crystals themselves, so they can be applied to polishing without scratching a workpiece to be polished, which is often caused by grains each having irregular shapes with sharp edges or angles.

The following examples are given in order to illutrate the present invention in detail without limiting the same.

### Example 1

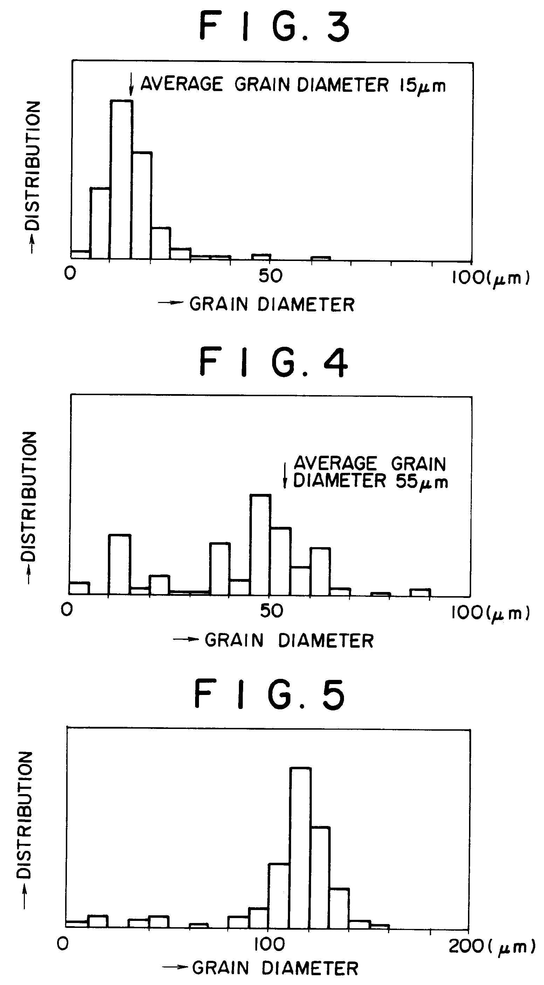

A diamond film having an average grain diameter of 10 µm was synthesized on a substrate of polycrystalline silicon by the use of a microwave CVD method. In this case, coating conditions were CH₄/H₂ = 3.52 : 100, a pressure of 53,33 hPa (40 Torr), a microwave (2.45 GHz) output of 550 W and a coating time of 3 hours and thus a diamond film with a thickness of about 50 µm was deposited. This substrate was then taken out of the coating apparatus and subjected to plasma etching in an oxygen-argon atmosphere under conditions of oxygen 35 vol %, argon 65 vol %, pressure 26,66 hPa (20 Torr), RF (13.56 MHz) output 300 W and etching time 2 hours. After etching, the silicon substrate was dissolved and removed in fluoronitric acid and the resulting diamond simple substance film was pulverized in a mortar to obtain a diamond powder with an average grain diameter of 15 µm. Observation of this powder by a scanning electron microscope showed a massive form pulverized along the grain boundary. When the grain size distribution of the powder was measured by a laser scattering method, a narrow grain size distribution as shown in Fig. 3 was obtained.

### Comparative Example 1

When the diamond film synthesized in an analogous manner to Example 1 was subjected to removal of the substrate without the above described heat treatment and pulverized, there was obtained only a powder having an average grain diameter of 55 µm and an irregular shape with many edges. The grain size distribution thereof was wide as shown in Fig. 4.

### Example 2

A diamond film having an average grain diameter of 100 µm was synthesized on a substrate of polycrystalline silicon by the use of a filament CVD method. In this case, coating conditions were CH₄/H₂ = 2.3 : 100, pressure 106,66 hPa (80 Torr), filament temperature 2000 °C and coating time 30 hours and thus a diamond film with a thickness of about 200 µm was deposited. This substrate was taken out of the coating apparatus and subjected to a heat treatment for etching in an argon atmosphere containing 15 % of oxygen (pressure 466,6 hPa (350 Torr)) at 650 °C for 10 hours. The silicon substrate was then dissolved and removed in fluoronitric acid and the resulting diamond simple substance film was ball milled to obtain a diamond powder with an average grain diameter of 120 µm. Observation of this powder showed a massive form pulverized along the grain boundary. The grain size distribution thereof was narrow as shown in Fig. 5.

### Example 3

A diamond film having an average grain diameter of 300 µm was synthesized on a substrate of molybdenum by the use of a plasma jet method. In this case, the synthesis conditions were CH₄/H₂ = 3 : 100, pressure 266,6 hPa (200 Torr), plasma voltage 110 V, plasma current 95 A and coating time 2 hours and thus a diamond film with a thickness of about 1.3 mm was deposited. This substrate was subjected to an etching treatment by placing it in an oxygen ion beam of 1 kV and 35 mA for 2 hours. The molybdenum substrate was then dissolved in aqua regia and removed and the resulting diamond simple substance film was pulverized in a mortar, thus obtaining diamond abrasive grains with an average grain diameter of 270 µm.

### Example 4

A diamond film having an average grain diameter of 300 µm was prepared by a plasma jet method in an analogous manner to Example 1 and the molybdenum substrate was dissolved and removed in aqua regia. The resulting simple substance diamond film was subjected to an etching treatment by placing it in oxygen at 40,0 hPa (30 Torr) and applying an argon excimer laser in a total quantity of 200 mJ from both the growth surface side and substrate surface side for 5 minutes and pulverized in a mortar to obtain diamond abrasive grains having an average diameter of 350 µm.

In the foregoing examples, the gaseous phase synthesis of diamond film was carried out by a microwave CVD method, hot filament CVD method or plasma jet method, but the gaseous phase synthesis of diamond according to the present invention can of course be effected by any of other methods such as flame method, laser CVD method, ion beam method and the like with the same benefits. Furthermore, it is found that the etching treatment in an oxygen-containing atmosphere can be carried out with the same effects by any of the heat treatment in an ordinary atmosphere, the heat treatment in an atmosphere under reduced pressure, the plasma etching treatment, the ion beam etching treatment, the laser etching treatment and the like.

## Claims

1. A process for the production of abrasives of single crystal or polycrystalline diamond, which comprises synthesizing a diamond film by a gaseous phase synthesis method, subjecting the resulting diamond film to an etching treatment in an atmosphere containing oxygen and pulverizing the diamond film.

2. A process as claimed in Claim 1, wherein the etching treatment is a heat treatment in an atmosphere containing oxygen at normal pressure or at reduced pressure.

3. A process as claimed in Claim 1, wherein the etching treatment is a plasma treatment in an atmosphere containing oxygen.

4. A process as claimed in Claim 1, wherein the etching treatment is an ion beam treatment in an atmosphere containing oxygen.

5. A process as claimed in Claim 1, wherein the etching treatment is a laser etching treatment in an atmosphere containing oxygen.

6. A process as claimed in any one of the preceding claims wherein the diamond film is coated onto a substrate.

7. A process as claimed in any one of the preceding claims wherein the substrate is polycrystalline silicon, single crystal silicon or molybdenum.

8. A process as claimed in any one of the preceding claims wherein the diamond film consists of polycrystalline diamond whose crystal grains have a grain diameter in the range of 0.5 to several hundreds µm.

## Patentansprüche

1. Verfahren zur Herstellung von Schleifmitteln aus monokristallinem oder polykristallinem Diamant, bei dem man einen Diamantfilm durch ein Gasphasensyntheseverfahren synthetisiert, den erhaltenen Diamantfilm einer Ätzbehandlung in einer Sauerstoff enthaltenden Atmosphäre unterwirft, und den Diamantfilm pulverisiert.

2. Verfahren gemäß Anspruch 1, bei dem die Ätzbehandlung eine Hitzebehandlung in einer Sauerstoff enthaltenden Atmosphäre bei normalem Druck oder reduziertem Druck ist.

3. Verfahren gemäß Anspruch 1, bei dem die Ätzbehandlung eine Plasmabehandlung in einer Sauerstoff enthaltenden Atmosphäre ist.

4. Verfahren gemäß Anspruch 1, bei dem die Ätzbehandlung eine Ionenstrahlbehandlung in einer Sauerstoff enthaltenden Atmosphäre ist.

5. Verfahren gemäß Anspruch 1, bei dem die Ätzbehandlung eine Laserätzbehandlung in einer Sauerstoff enthaltenden Atmosphäre ist.

6. Verfahren gemäß einem der vorhergehenden Ansprüche, bei dem der Diamantfilm auf ein Substrat aufgebracht wird.

7. Verfahren gemäß einem der vorhergehenden Ansprüche, bei dem das Substrat polykristallines Silizium, monokristallines Silizium oder Molybdän ist.

8. Verfahren gemäß einem der vorhergehenden Ansprüche, bei dem der Diamantfilm aus polykristallinem Diamant besteht, dessen Kristallkörner einen Korndurchmesser im Bereich von 0,5 bis einige hundert Mikrometer (µm) haben.

## Revendications

1. Procédé pour la production d'abrasifs de diamant monocristallin ou polycristallin, qui comprend les opérations consistant à synthétiser un film de diamant par un procédé de synthèse en phase gazeuse, soumettre le film de diamant obtenu à une attaque dans une atmosphère renfermant de l'oxygène et à pulvériser le film de diamant.

2. Procédé selon la revendication 1, dans lequel l'attaque est un traitement thermique dans une atmosphère renfermant de l'oxygène à une pression normale ou à une pression réduite.

3. Procédé selon la revendication 1, dans lequel l'attaque est un traitement au plasma dans une atmosphère renfermant de l'oxygène.

4. Procédé selon la revendication 1, dans lequel l'attaque est un traitement par faisceau ionique dans une atmosphère renfermant de l'oxygène.

5. Procédé selon la revendication 1, dans lequel l'attaque est un traitement d'attaque par laser dans une atmosphère renfermant de l'oxygène.

6. Procédé selon l'une quelconque des revendications précédentes, dans lequel le film de diamant est couché sur un support.

7. Procédé selon l'une quelconque des revendications précédentes, dans lequel le support est du silicium polycristallin, du silicium monocristallin ou du molybdène.

8. Procédé selon l'une quelconque des revendications précédentes, dans lequel le film de diamant consiste en diamant polycristallin dont les grains cristallins ont un diamètre compris entre 0,5 µm et plusieurs centaines de µm.
